Europäisches Patentamt

European Patent Office

Office européen des brevets

(11) Publication number: **0 357 509**
**A1**

## EUROPEAN PATENT APPLICATION

(21) Application number: **89402370.4**

(22) Date of filing: **30.08.89**

(51) Int. Cl.5: **H 01 B 12/00**
H 01 L 39/24, C 04 B 35/00

(30) Priority: **30.08.88 JP 216035/88**
**06.02.89 JP 27304/89**

(43) Date of publication of application:
**07.03.90 Bulletin 90/10**

(84) Designated Contracting States:
**CH DE FR GB IT LI NL**

(71) Applicant: **SUMITOMO ELECTRIC INDUSTRIES, LTD**
**5-33, Kitahama 4-chome Chuo-ku**
**Osaka 541 (JP)**

(72) Inventor: **Itozaki, Hideo c/o Itami Works of**
**Sumitomo Electric Ind., Ltd. 1-1, Koyakita 1-chome**
**Itami-shi Hyogo (JP)**

**Harada, Keizo c/o Itami Works of**
**Sumitomo Electric Ind., Ltd. 1-1, Koyakita 1-chome**
**Itami-shi Hyogo (JP)**

**Oyama, Hitoshi c/o Itami Works of**
**Sumitomo Electric Ind., Ltd. 1-1, Koyakita 1-chome**
**Itami-shi Hyogo (JP)**

**Yazu, Shuji c/o Itami Works of**
**Sumitomo Electric Ind., Ltd. 1-1, Koyakita 1-chome**
**Itami-shi Hyogo (JP)**

(74) Representative: **Ballot, Paul Denis Jacques**
**Cabinet Ballot-Schmit 7, rue le Sueur**
**F-75116 Paris (FR)**

(54) Process for preparing a thallium-type compound oxide superconductor.

(57) A novel process for preparing superconductor of thallium-containing compound oxide such as Tl-Ba-Ca-Cu system.

In the present invention, firstly an intermediate compound oxide containing metal elements of the superconductor except thallium is prepared and then the intermediate compound oxide is contacted with thallium oxide vapour at room temperature between 800 and 1,000 °C so that thallium oxide is reacted with said intermediate compound oxide.

FIGURE 1

EP 0 357 509 A1

## Description

## PROCESS FOR PREPARTING A THALLIUM-TYPE COMPOUND OXIDE SUPERCONDUCTOR

### Background of the Invention

### Field of the invention

The present invention relates to a novel process for preparing compound oxide type superconductors, more particularly, a novel process for preparing superconductors of thallium-containing compound oxides such as Tl-Ba-Ca-Cu system.

### Description of the related art

The superconductivity is a phenomenon which is explained to be a kind of phase change of electrons under which the electric resistance become zero and the perfect diamagnetism is observed. Under the superconductivity, permanent current of high density flow without any loss. Therefore, when the technology of superconductivity can be applied to electric power transmission, power loss of about 7 % which is lost in the electric power transmission today can be saved greatly. Development of superconductor is also expected in the field of measurement and of medical treatment such as NMR, $\pi$ neutrons medical treatment or high-energy physical experiments. In the applications of electromagnets for generating strong magnetic fields, the technology of superconductivity is expected to accelerate development of the technology of fusion power generation, MHD power generation, magnetic levitation trains and magnetically propelling ships.

Several superconducting devices have been proposed and developed in electronics. A typical application of the superconductor is Josephson device in which quantum efficiency is observed macroscopically when an electric current is passed through a weak junction arranged between two superconductors. The tunnel junction type Josephson device is expected to be a high-speed and low-power consuming switching device owing to a smaller energy gap of the superconducting material. Development of the superconducting devices such as high-speed logic units or of no power-loss wiring materials is also demanded in the field of high-speed computers in which the power consumption per unit area is reaching to the upper limit of the cooling capacity with increment of the integration density in order to reduce energy consumption.

The critical temperature "Tc" of superconductivity, however, could not exceed 23.2 K of $Nb_3Ge$ which was the the highest Tc for the past ten years. The possibility of an existence of new types of superconducting materials having much higher Tc was revealed by Bednorz and Müller, who discovered a new oxide type superconductor in 1986 (Z. Phys. B64, 1986 p189).

It had been known that certain ceramic materials of compound oxides exhibit the property of superconductivity. For example, U. S. patent No. 3,932,315 discloses Ba-Pb-Bi type compound oxide which shows superconductivity and Japanese patent laid-open No. 60-173,885 discloses that Ba-Bi type compound oxides also show superconductivity. These superconductors, however, possess rather lower transition temperatures of about 10 K and hence usage of liquidized helium (boiling point of 4.2 K) as cryogen is indispensable to realize superconductivity.

The new type compound oxide superconductor discovered by Bednorz and Müller is represented by [La, Sr]$_2$CuO$_4$ which is called the K$_2$NiF$_4$-type oxide having a crystal structure which is similar to known perovskite type oxides. The K$_2$NiF$_4$-type compound oxides show such higher Tc as 30 K which are extremely higher than known superconducting materials.

It was also reported that C. W. Chu et al. discovered, in the United States of America, another superconducting material so called YBCO type represented by YBa$_2$Cu$_3$O$_{7-x}$ having the critical temperature of about 90 K in February 1987 (Physical Review letters, Vol. 58, No. 9, p908). Maeda et al reported the other type new superconducting material of Bi-Sr-Ca-Cu-O system (Japanese Journal of Applied Physics. Vol. 27, No. 2, p 1209 to 1210).

Thallium type compound oxides are also high Tc superconductors of more than 100 K. The present inventors disclosed several kinds of thallium type compound oxides superconductors in a US patent application No. 223,634 filed on July 25, 1988 and Hermann et al. reported Tl-Ba-Ca-Cu-O system in Appl. Phys. Lett. 52 (20) p 1738). Thallium type compound oxides are chemically much stable than the abovementioned YBCO type compound oxide and have such a very important merit that high Tc superconductors of higher than 100 K can be realized without using rear earth elements as a constituent element so that the production cost can be reduced.

The above-mentioned new types superconducting materials can be obtained by solid reaction in a bulk form of sintered block which was obtained by sintering a powder mixture of oxides or carbonates of constituent metal elements which has predetermined atomic ratios.

They can also be deposited on a substrate in a form of a thin film by physical vapour deposition (PVD) technique such as RF sputtering, vacuum deposition, ion-plating or MBE or chemical vapor deposition (CVD) technique such as thermal CVD, plasma CVD, photo-CVD or MOCVD.

In the case of production of thallium type oxide superconductors, however, there is a special problem, because thallium (Tl) is a very volatile element whose vapour pressure is extremely higher than the other constituent elements, so that it is very difficult to control the composition of the product and because thallium is toxic for human and pollute the environment. This means that special attention is required in the conventional solid reaction of thallium type compound oxides.

An object of the present invention is to overcome the problem of the conventional process and to provide a novel process for preparing high Tc thallium type superconductors such as Tl-Ba-Ca-Cu system of high quality easily and safely.

## Summary of the Invention

The present invention provides a process for preparing superconductor of thallium-containing compound oxide, characterized by the steps comprising preparing "an intermediate compound oxide" containing metal elements except thallium which are constituent elements of the product superconductor and then subjecting the intermediate compound oxide to heat-treatment at a temperature between 800 and 1,000 °C in an atmosphere of thallium oxide vapour, so that thallium oxide is reacted with the intermediate compound oxide to produce the product superconductor.

The thallium oxide vapour is preferably created by heating thallium oxide powder in a chamber.

The product superconductor according to the present invention is preferably in a form of thin film deposited on a substrate and also can be a block or pre-shaped article such as coil or a ring.

The process according to the present invention is applicable to any thallium-containing compound superconductor including the following typical system represented by the general formula:

$Tl_2(Ba_{1-q}, Ca_q)_mCu_nO_{p+y}$

in which "m", "n", "q" and "y" are numbers each satisfying respective ranges of $3 \leqq m \leqq 5, 2 \leqq n \leqq 4, 0 < q < 1$ and $-1 \leqq y \leqq +1$ and $p = (6+m+n)$.

The compound oxides of this system consist mainly of the following formula: $Tl_2Ba_2Ca_1Cu_2O_8$ or $Tl_2Ba_2Ca_1Cu_3O_{10}$ each of which can be doubled in its crystal structure along c-axis. These compound oxide show Tc of 100 K and 125 K respectively.

As the other type thallium-containing compound oxides to which the present invention is applicable, it can be mentioned the following systems:

| | |
|---|---|
| Tl-Sr-Ca-Cu-O system | (75 to 100K), |
| Tl-Pb-Sr-Ca-Cu-O system | (80 to 122 K), |
| Tl-Pb-Ba-Ca-Cu-O system | (90 to 122 K), |
| (Tl,La,Pb)-Sr-Ca-Cu-O system | (100 K), |
| Tl-Pb-Ca-Ce-Sr-Cu-O system | (95 K), |
| Tl-Ba-(Y,Ca)-Cu-O system | (92 K), |
| Tl-Ba-Ce-Cu-O system | (90 K), |
| (Tl,Ln)-Sr-Ca-Cu-O system | (80 to 90 K), |
| (Bi, Tl)-Sr-Cu-O system | (90 K), |
| Nd-Tl-Sr-Cu-O system | (44 K), |
| Pb-Tl-Sr-Cu-O system | (42 K), |
| La-Tl-Sr-Cu-O system | (37 K) and |
| Tl-Bi-Sr-Ca-Cu-O system | (25 K). |

(note) Ln : lanthanide element

## Brief Description of the drawings

FIG. 1 is an illustrative view of an apparatus which can be used for carrying out the process according to the present invention.

FIG. 2 (a) and (b) illustrate typical X-ray diffraction patterns observed on intermediate compound oxides used in the process according to the present invention.

## Description of the Preferred Embodiments

As described above, in the case of thallium type compound oxides, it is very difficult to control effectively the composition of the product, because thallium (Tl) is a very volatile element whose vapour pressure is extremely higher than the other constituent elements.

The essence of the present invention reside in that the final product of compound oxide is not produced directly as is the case of the conventional process but is produced by two steps. Namely, in the process according to the present invention, an intermediate compound oxide or a parent body is prepared firstly from the other constituent elements except thallium which have extremely higher vapour pressure comparing to the other constituent elements at the first stage and then thallium oxide is added to the resulting intermediate compound oxide or a parent body obtained.

The intermediate compound oxide or parent body can be in a form of a block or a shaped article but is preferably in a form of a thin film since the superconductor prepared by the process according to the present invention is obtained in the neighbourhood of a surface of the intermediate compound or parent body.

The intermediate compound oxide may have crystalline structure but preferably have amorphous structure in order to obtain good result of superconductivity of thallium-type compound oxide.

In fact, when the intermediate compound oxide have the crystalline structure, it may be difficult to add or diffuse thallium atoms into the intermediate compound oxide satisfactorily, because a stable crystal structure has been created in such crystalline structure. Still more, in this case, it may be difficult to obtain superconductors having a homogeneous composition because the intermediate compound oxide such as Ba-Ca-Cu-O system is composed of a plurality of different phases and contain crystalline grains each having different phases, so that the final product obtained after thallium is added contains a plurality of different phases.

To the contrary, when the intermediate compound oxide have amorphous structure, such addition and diffusion of thallium atoms can be performed effectively because the intermediate compound oxide itself have homogeneous composition and quality and amorphous structure is thermodynamically unstable condition.

The first stage for preparing the intermediate compound oxide of the other elements except thallium and oxygen can be effected by the conventional solid reaction, physical vapour deposition or chemical vapour deposition.

The block or shaped article of the intermediate compound oxide or parent body can be prepared by solid reaction or sintering technique. In this case, a sintered mass of the intermediate compound oxide containing the other elements except thallium is prepared by the steps of mixing powders of oxides, carbonates, nitrate or fluorides each containing at least one of the other constituent metal elements of the intermediate compound oxide in such a manner that a powder mixture contains the constituent metal elements in predetermined atomic ratios and then sintering the powder mixture. It is preferably to repeat the sintering operation and pulverization for more than one time. Amorphous block of the intermediate compound oxide can be produced by heating the powder mixture at about 1,500 °C and then the resulting melt is quenched rapidly. This solid reaction can be effected without difficulty because the vapour pressures of the other metal elements except thallium are not so much different from each other.

As stated above, the intermediate compound oxide or parent body is preferably in a form of a thin film. Namely, the superconductor prepared by the process according to the present invention is obtained in the neighborhood of a surface of the intermediate compound or parent body because thallium react mainly with the surface of the intermediate compound.

When a thin film is used as the intermediate compound or parent body, such thin film can be prepared by physical vapour deposition (PVD) technique such as RF magnetron sputtering, vacuum deposition, ion-plating, MBE or by chemical vapor deposition (CVD) technique such as thermal CVD, plasma CVD, photo CVD, MOCVD or the like. When RF magnetron sputtering, vacuum deposition or ion-plating method is used as the physical vapour deposition technique, the atomic ratios of metal elements contained in a vapour source or a target is adjusted according to difference in the evaporation rate as well as difference in adsorption of metal elements to the substrate. The vapour source is preferably a sintered mass which is prepared by powder-sintering technique of a material power mixture comprising metal elements and/or their oxides or carbonates or a sintered powder which is obtained by pulverizing the sintered mass. The vapour source can be also divided into a plurality of segments. In the case of the molecular beam epitaxy (MBE), elemental metals of Tl, Ba, Ca and Cu or their compounds such as their oxides are evaporated by means of a K-cell or an ion beam gun. In this case, oxygen is supplied, if necessary, separately or additionally into an evaporation atmosphere.

The substrate on which the intermediate compound oxide is deposited is preferably a single crystal of MgO, $ZrO_2$, $SrTiO_3$, $LiNbO_3$, $LiTaO_3$, $LaAlO_3$, $LaGaO_3$ or the like. It may be used $LiAlO_3$, $LiCaO_3$, $KTaO_3$, $CaF_2$, $BeF_2$, CSZ, YSZ or silicon. When a single crystal of silicon is used as the substrate, a buffer layer of MgO or $ZrO_2$ is preferably interposed between the intermediate compound oxide layer and the substrate.

The final superconductor obtained by the process according to the present invention show crystalline anisotropy in electric resistance, so that the current passing along a direction which is in parallel to a plane defined by a-axis and b-axis of the crystal show a very high critical current density, while the current passing along c-axis is relatively lower. Therefore, it is preferable to give a desired orientation of crystal to the thin film. For example, when the thin film of the intermediate compound oxide is deposited on {001} plane of a single crystal of MgO or SrTiO$_3$, the c-axis of the crystal of the thin film deposited is oriented perpendicular or nearly perpendicular to a surface of the thin film, so that the critical current density (Jc) along the surface is improved. In special applications, it is possible to use {110} plane of the substrate of SrTiO$_3$ in order to orient the c-axis of the crystal of the thin film deposited in parallel to the surface so that higher current density is obtained to the direction of depth. The substrate made of a single crystal of MgO or SrTiO$_3$ are preferable because their thermal expansion coefficient is similar to that of the intermediate compound oxide and hence the thin film of the intermediate compound oxide is not receive serious thermal shock or stress by heat history caused by heat and cool of the substrate.

In a preferred embodiment, an amorphous thin film of an intermediate compound oxide of Ba-Ca-Cu-O system is deposited firstly on a substrate made of a single crystal of MgO by sputtering technique. A target used in the sputtering is a sintered block of Ba-Ca-Cu-O system compound oxide or sintered powder obtained by pulverizing the sintered block. In this case, the substrate is heated at a temperature which is blow 600 °C in order to obtain the amorphous film. Then, the resulting amorphous thin film is exposed to or contacted with a mixture of thallium vapour and oxygen gas or thallium oxide vapour at a temperature between 800 and 1,000 °C so that thallium/oxygen or thallium oxide react with the intermediate compound oxide.

The contact of the intermediate compound oxide with the mixture of thallium vapour and oxygen gas or thallium oxide vapour can be effected in a closed chamber in which thallium oxide vapour is created by heating a vapour source such as thallium oxide powder. In a variation, a mixture of thallium vapour and oxygen gas or thallium oxide vapour produced outside the chamber can be introduced into the the chamber.

In the second stage, the intermediate compound oxide is preferably heated at a temperature between 800 and 1,000 °C. If the temperature is not higher than 800 °C, the intermediate compound oxide is not activated so that the reaction with thallium don't proceed satisfactorily. To the contrary, if the the temperature is not lower than than 1,000 °C, the trapped thallium atoms are escape from the the intermediate compound oxide so that the objective thallium containing compound oxide is not obtained.

It is preferable to heat the vapour source at higher temperature than the intermediate compound oxide. If necessary, a suitable flux can be used in order to increase vapour pressure of the vapour source such as thallium compound. This heat-treatment is continued preferably for a time duration between one minute and 5 hours.

It is also preferable to increase the partial pressure of oxygen in the chamber in order to control the oxygen contents in the final product. The partial pressure of oxygen depend on the nature of the compound oxides to be produced and is selected usually about 1 atm.

Now, an apparatus for carrying out the present invention will be described with reference to the attached drawings.

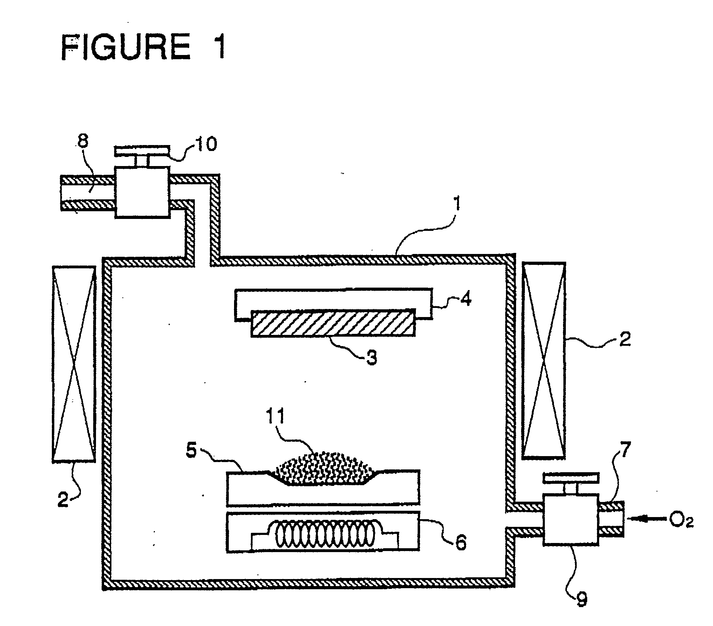

FIG. 1 is an illustrative view of an apparatus which can be used for carrying out the process according to the present invention. The apparatus is a closed furnace 1 which is provided with an inlet port 7 having a valve 9, an outlet port 8 having a valve 10, a substrate holder 4, a boat 5 for receiving thallium-containing compound thereon and a heater 6 for heating the boat 6. The furnace 1 is surrounded by an outer heater 2 which heat the furnace from outside. The boat 5 is faced to the substrate holder 4 so that thallium vapour produced from the boat 5 is directed directly to a substrate 3 supported on the holder 4. The furnace 1 has a relief valve (not shown).

In operation, the substrate 3 having a thin film of intermediate compound oxide there is secured on the substrate holder 4. A block of intermediate compound oxide can be used in place of the substrate 3. Powder of thallium-containing compound such as thallium oxide is placed on the boat 5. Firstly, the furnace 1 is vacuumed through the outlet port 8. After the valve 10 is closed, oxygen gas is introduced into the furnace 1 and then the valve 9 is closed. Then, the heater 6 is energized to evaporate the thallium-containing compound and simultaneously the outer heater 2 is also energized to heat the substrate 3 having the intermediate compound oxide.

According to the present invention, following advantages are obtained:

    (1) Superconductors of thallium-containing compound oxide are prepared safely because toxic thallium gas is handled in a closed chamber and hence there is no danger of pollution.

    (2) The proportion of thallium in the superconductor can be controlled precisely.

    (3) Homogeneous superconductors can be obtained.

    (4) The operation for adding thallium can be carried out easily in relatively short time. Therefore, the process according to the present invention is applicable to production of elongated articles such as wire.

Now, the present invention will be described with reference to examples, but the scope of the invention should not be limited to them.

Example 1

In this example, a parent body or an intermediate compound oxide was in a form of a thin film which was prepared by magnetron RF sputtering method.

A target used in the RF-magnetron sputtering was prepared by mixing intimately powders of oxides of Ba, Ca, and Cu in such proportions that the atomic ratios of respective elements of Ba : Ca : Cu became 2 : 2 : 3 and then sintering the powder mixture. The resulting sintered mass of Ba-Ca-Cu compound oxide was used as the target. A thin film of Ba-Ca-Cu compound oxide was deposited on {110} plane of a MgO substrate under the following condition:

Substrate temperature : 800°C
Sputtering gas : 0.01 to 0.1 Torr Ar/$O_2$ = 1:1
High-frequency power : 100 W
Thickness of the film : 0.2 μm

The resulting substrate 3 having the thin film of Ba-Ca-Cu compound oxide was secured to the holder 4 as is shown in FIG. 1. The boat 5 which was faced to the substrate 3 was filled with thallium oxide powder.

The furnace 1 was vacuumed through the outlet port 8. After the valve 10 was closed, oxygen gas was introduced into the furnace 1 and then the valve 9 was closed. Then, the furnace was heated at a temperature of 970 °C by the heater 2 and the heater 6 was energized to heat the boat 5 up to 1,000 °C. When the boat 5 was heated at 1,000 °C, this temperature was maintained for five minute and then the heaters were de-energized.

After the furnace was cooled down to room temperature, the MgO substrate was taken out of the furnace to measure the critical temperature. Namely, the MgO substrate was dipped in liquid helium in a cryostat at 8 K in order to confirm that the thin film deposited on the substrate was changed to a superconductor, the temperature was elevated gradually to determine a critical temperature (Tc) where the thin film showed ordinal resistance.

It was confirmed that the critical temperature (Tc) of the thin film was 110 K.

Example 2

Preparation of the intermediate compound oxide

The parent body or intermediate compound oxide was produced in a form of a thin film which was prepared by magnetron RF sputtering method.

A target used in the RF-magnetron sputtering was prepared by mixing intimately powders of oxides of Ba, Ca and Cu in such proportions that the atomic ratios of respective elements of Ba : Ca : Cu became 2 : 2 : 3 and then sintering the powder mixture at 900 °C for 2 hours. The resulting sintered mass of Ba-Ca-Cu compound oxide was pulverized to a sintered powder which was used as a powder target. Several thin films of Ba-Ca-Cu compound oxide were deposited on {100} plane of MgO substrates under the following common condition except substrate temperature:

Substrate temperature : shown in Table 1
Sputtering gas pressure : 5 x $10^{-2}$ Torr
Sputtering gas : Ar + $O_2$ ($O_2$ = 20%)
RF-frequency power density : 0.64 W/cm$^2$
Thickness of the film : 1 μm

Crystalline structures of the resulting thin films were evaluated by measuring X-ray diffraction patter.

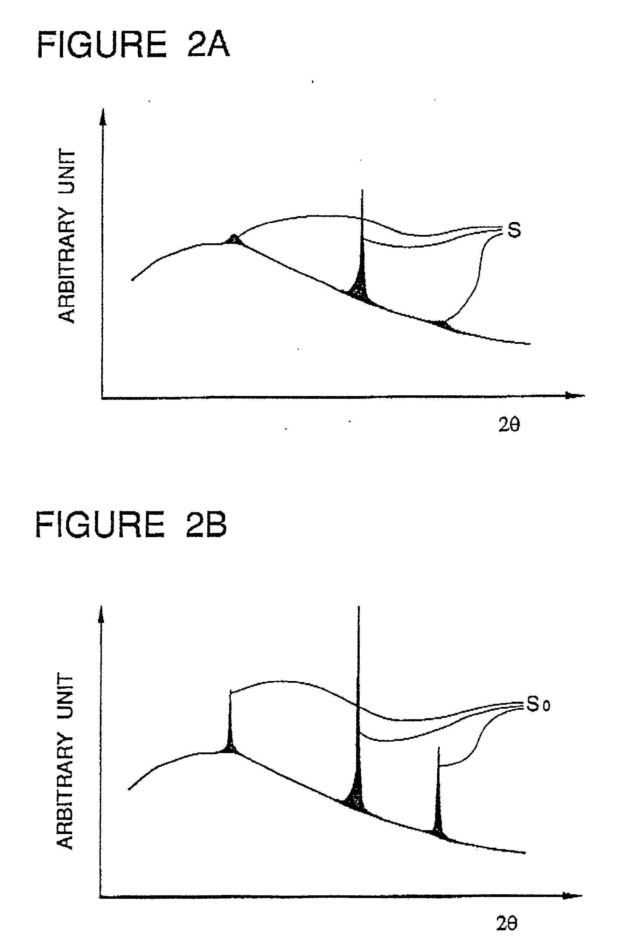

FIG 2 (a) and (b) illustrate typical examples of X-ray diffraction patters of the thin films obtained FIG. 2 (a) is a X-ray diffraction patter of less crystalline or amorphous thin film, while FIG 2 (b) is a X-ray diffraction patter of well crystalline thin film.

In this example, the degree of crystallization (Xc) is defined by a percent (%) of areas (S/$S_0$) of peaks calculated at an identical diffraction angle (2θ) : Xc = (S/$S_0$) x 100. The area "$S_0$" was an area of a peak observed in a X-ray diffraction patter of well crystalline thin film which was prepared at the substrate temperature is 800 °C, while the area "S" was an area of a peak calculated at an identical diffraction angle (2θ) and observed in a X-ray diffraction patter of a thin film which was prepared at different substrate temperature. When this value Xc < 10, the thin film is considered to be amorphous. The results are summarized in Table 1.

Table 1

| Substrate temperature (°C) | Xc | Degree of Crystallization |
|---|---|---|
| 800 | 100 | crystalline |
| 650 | 85 | crystalline |
| 600 | 8 | amorphous |
| 550 | 4 | amorphous |
| 350 | 0 | amorphous |

6

### Preparation of the superconductor

Two series of samples of thin films as the intermediate compound oxides were prepared under the same conditions except the substrate temperature. Namely, the first series samples were prepared at the substrate temperature of 350 °C and hence the thin films were amorphous, while second series samples were prepared at the substrate temperature of 650 °C and hence the thin films were crystalline.

Both series samples were subjected to heat-treatment with thallium oxide vapour as following:

Each MgO substrate 3 having the amorphous thin film of Ba-Ca-Cu compound oxide was secured to the holder 4 as is shown in FIG. 1. The boat 5 which was faced to the substrate 3 was filled with thallium oxide ($Tl_2O_3$) powder.

The furnace 1 was vacuumed through the outlet port 8. After the valve 10 was closed, oxygen gas was introduced into the furnace 1 and then the valve 9 was closed. Then, the heater 6 was energized to heat the boat 5 up to 1,000 °C. When the boat 5 was heated at 1,000 °C, this temperature was maintained for five minute so that interior of the furnace is filled with $Tl_2O_3$ vapour. Then, the furnace was heat-treated at 930 °C (hereinafter heat-treatment temperature) by the heater 2 and this temperature was maintained for one hour and then the furnace 1 is further heated at 850 °C for three hours.

After the furnace was cooled down to room temperature, the MgO substrate was taken out of the furnace to measure the critical temperature and the critical current density.

Namely, the the MgO substrate was dipped in liquid helium in a cryostat at 8 K in order to confirm that the thin film deposited on the substrate was changed to a superconductor, the temperature was elevated gradually to determine a critical temperature (Tc) where the thin film showed ordinal resistance. The critical current density (Jc) of the thin films obtained was also determined at 77.0 K and is expressed by $A/cm^2$.

The condition of heat-treatment (heat-treatment temperature) and the results (Tc and Jc) are summarized in table 2.

Table 2

| Heat-treatment temperature (°C) | Amorphous thin film | | Crystalline thin film | |
|---|---|---|---|---|
| | Tc | Jc | Tc | Jc |
| 1,020 | -- | -- | -- | -- |
| 970 | 110 | $4 \times 10^5$ | 104 | $2 \times 10^4$ |
| 930 | 115 | $1 \times 10^6$ | 100 | $1 \times 10^4$ |
| 880 | 100 | $5 \times 10^5$ | 84 | $5 \times 10^3$ |
| 840 | 82 | $3 \times 10^5$ | 80 | $1 \times 10^3$ |
| 790 | -- | -- | -- | -- |

Tc : K (R=O)  Jc: $A/cm^2$ (at 77.3 K)

**Claims**

1. A process for preparing superconductor of thallium-containing compound oxide, characterized by the steps comprising preparing an intermediate compound oxide composed of metal elements which are constituent elements of said superconductor except thallium and oxygen, and subjecting said intermediate compound oxide to heat-treatment at a temperature between 800 and 1,000 °C in an atmosphere containing thallium oxide vapour so that thallium oxide react with said intermediate compound oxide to produce the superconductor.

2. The process set forth in claim 1 wherein said thallium oxide vapour is created by heating thallium oxide powder in a chamber.

3. The process set forth in claim 1 or 2 wherein said superconductor is in a form of a thin film deposited on a substrate.

4. The process set forth in any one of Claim 1 to 3 wherein said intermediate compound oxide has a form of a thin film prepared on the substrate by physical vapour deposition technique.

5. The process set forth in Claim 3 or 4 wherein the substrate is a single crystal of MgO, $SrTiO_3$, $LaAlO_3$ or $LaGaO_3$.

6. The process set forth in Claim 5 wherein the thin film is deposited on {100} plane or {110} plane of the substrate.

7. The process set forth in Claim 4 wherein said physical vapour deposition technique is sputtering

8. The process set forth in Claim 7 wherein wherein a target used in the sputtering is a sintered block or sintered powder of a compound oxide containing metal elements which are constituent elements of said intermediate compound oxide.

9. The process set forth in Claim 8 wherein said sintered block or sintered powder is prepared by mixing powders of oxides, carbonates, nitrate or fluorides each containing at least one of constituent metal elements of said intermediate compound oxide in such a manner that the resulting powder mixture contains the constituent metal elements except thallium in predetermined atomic ratios and then by sintering the powder mixture.

10. The process set forth in Claim 4 wherein said thin film of the intermediate compound oxide is an amorphous film.

11. The process set forth in Claim 10 wherein said amorphous film is prepared by heating the substrate at a temperature lower than 600 °C during the sputtering.

12. The process set forth in any one of Claim 1 to 11 wherein the superconducting thin film is made of a compound oxide of Tl, Ba, Ca and Cu.

13. The process set forth in Claim 12 wherein the compound oxide consists mainly of compound oxides represented by the general formula: $Tl_2(Ba_{1-q}, Ca_q)_m Cu_n O_{p+y}$

in which "m", "n", "q" and "y" are numbers each satisfying respective ranges of $3 \leqq m \leqq 5, 2 \leqq n \leqq 4, 0 < q < 1$ and $-1 \leqq y \leqq +1$ and $p = (6+m+n)$.

# FIGURE 1

# FIGURE 2A

# FIGURE 2B

| DOCUMENTS CONSIDERED TO BE RELEVANT | | | EP 89402370.4 |
|---|---|---|---|

| Category | Citation of document with indication, where appropriate, of relevant passages | Relevant to claim | CLASSIFICATION OF THE APPLICATION (Int. Cl. 5) |
|---|---|---|---|
| X;Y | APPLIED PHYSICS LETTERS, vol. 53, no. 6, August 8, 1988, I. SHIH et al. "Multilayer deposition of Tl Ba Ca Cu O films" pages 523-525 * Abstract; page 24, left hand column, 2nd paragraph * | 1,3,4, 12,13; 5-9 | H 01 B 12/00 H 01 L 39/24 C 04 B 35/00 |
| Y | JAPANESE JOURNAL OF APPLIED PHYSICS, vol. 27, no. 5, May 1988 M. NAKAO et al. "Sputtered Tl Ca Ba Cu O thin films with zero resistivity at 98 K" pages L849-L851 * Abstract; page L 849, left hand column, 2nd paragraph * | 5-9 | |

**TECHNICAL FIELDS SEARCHED (Int. Cl. 5)**

H 01 B 12/00
H 01 L 39/00
C 04 B 35/00

The present search report has been drawn up for all claims

| Place of search | Date of completion of the search | Examiner |
|---|---|---|
| VIENNA | 08-11-1989 | KUTZELNIGG |